# EUROPÄISCHE PATENTSCHRIFT

(11) **EP 3 750 220 B1**
(45) Veröffentlichungstag und Bekanntmachung des Hinweises auf die Patenterteilung: **28.02.2024**
(21) Anmeldenummer: 18830880.3
(22) Anmeldetag: 28.12.2018
(51) Int. Cl.: B60L 3/00, H02H 7/08, B60L 3/04, H02J 7/14, H02P 29/02, H02J 7/00, H02M 1/32, G05B 9/02

(54) **VERFAHREN UND VORRICHTUNG ZUR EXTERNEN ÜBERWACHUNG EINES STROMRICHTERS**
METHOD AND DEVICE FOR EXTERNAL MONITORING OF A CONVERTER
PROCÉDÉ ET DISPOSITIF POUR LA SURVEILLANCE EXTERNE D'UN CONVERTISSEUR DE COURANT

(30) Priorität: 08.02.2018 DE 102018201953; 25.09.2018 DE 102018216334
(43) Veröffentlichungstag der Anmeldung: 16.12.2020
(73) Patentinhaber: Robert Bosch GmbH, 70442 Stuttgart (DE)
(72) Erfinder: SCHILD, Johannes, 74232 Abstatt (DE)
(86) Internationale Anmeldenummer: PCT/EP2018/097102
(87) Internationale Veröffentlichungsnummer: WO 2019/154555

(56) Entgegenhaltungen:
- WO-A1-03/069768
- WO-A1-2018/001598
- DE-A1-102011 050 719
- US-A1- 2010 273 072

## Beschreibung

Die Erfindung betrifft ein Verfahren und eine Vorrichtung zur externen Überwachung eines Stromrichters. Ferner betrifft die Erfindung einen Antriebsstrang mit einer entsprechenden Vorrichtung und ein Kraftfahrzeug mit einem Antriebsstrang sowie ein Computerprogrammprodukt und ein maschinenlesbares Speichermedium.

### Stand der Technik

Ein Elektro- oder Hybridfahrzeug wird durch zumindest einen Elektromotor, der durch einen Stromrichter gesteuert wird, sowie eventuell zusätzlich durch einen Verbrennungsmotor angetrieben. Die Fahrerwunscherfassung und Aufteilung des Soll-Drehmoments auf die Antriebe wird in einer Vehicle Control Unit (VCU) durchgeführt und die Momentenstellung erfolgt in einer der elektrischen Maschine zugewiesenen Steuerelektronik des Stromrichters.

Eine solche Steuerelektronik weist in der Regel ihre eigene Überwachung auf und ist dadurch zu einem gewissen Maß eigensicher. Ein Maß für die Integrität der Überwachung ist der ASIL nach ISO 26262, wobei es im Rahmen der ASIL die Integritätsstufen ASIL A, B, C und D gibt.

Herkömmliche Stomrichter weisen oft eine Integritätsstufe ASIL B zur Sicherstellung einer maximal zulässigen Abweichung zwischen einem Ist-Moment und einem Soll-Moment auf. In manchen Kraftfahrzeuganwendungen, beispielsweise beim Einsatz starker E-Motoren in Verbindung mit Hinterachsantrieb und beispielsweise einem leichten Fahrzeuggewicht, kann jedoch ein höherer ASIL gefordert sein, insbesondere in Fahrsituationen mit höherer Geschwindigkeit, z.B. größer 40 km/h, und für hohe Abweichungen von Ist- und Soll-Moment.

Die DE 10 2015 226 161 A1 offenbart ein elektrisches Antriebssystem mit einem ersten und zweiten Wechselrichter, einer Stromwandlerschaltung, ausgelegt, einen zwischen den Ausgangsanschlüssen der ersten und zweiten Wechselrichter und der elektrischen Maschine fließenden Phasenstrom zu überwachen. Die Druckschriften WO 03/069768 A1, US 2010/273072 A1 und WO 2018/001598 A1 offenbaren jeweils Verfahren und Vorrichtungen zur Überwachung eines elektrischen Antriebsystems.

### Offenbarung der Erfindung

Die vorliegende Erfindung schafft ein Verfahren zur externen Überwachung eines Stromrichters gemäß Anspruch 1.

Die vorliegende Erfindung schafft des Weiteren eine Vorrichtung zur Überwachung eines Stromrichters gemäß Anspruch 8.

Die vorliegende Erfindung schafft darüber hinaus ein Computerprogrammprodukt, das dazu eingerichtet ist, das erfindungsgemäße Verfahren auszuführen sowie ein maschinenlesbares Speichermedium, auf dem das Computerprogrammprodukt gespeichert ist.

Die Erfindung betrifft überdies einen Antriebsstrang eines Kraftfahrzeugs mit der erfindungsgemäßen Vorrichtung, einem Stromrichter, einer ersten Steuerelektronik und einer elektrischen Maschine oder einer Energiequelle. Die Erfindung betrifft des Weiteren ein Kraftfahrzeug mit dem erfindungsgemäßen Antriebsstrang.

Eine Idee der vorliegenden Erfindung ist es, durch das Erfassen eines vom Stromrichter aufgenommenen Stroms und einer vom Stromrichter aufgenommenen Spannung durch eine von der ersten Steuerelektronik unabhängige Strom-/Spannungs-Sensoreinrichtung, vorstehend genannte Parameter extern zu erfassen, d.h., dass diese Parameter nicht durch die den Stromrichter steuernde erste Steuerelektronik bereitgestellt, sondern unabhängig hiervon durch eine externe Vorrichtung ermittelt und bereitgestellt werden. Hierdurch kann die Integrität des Gesamtsystems erhöht und somit die Sicherheit des Elektro- oder Hybridfahrzeugs gesteigert werden.

Vorteilhafte Ausführungsformen und Weiterbildungen ergeben sich aus den Unteransprüchen sowie aus der Beschreibung unter Bezugnahme auf die Figuren.

Gemäß einer weiteren bevorzugten Weiterbildung ist vorgesehen, dass die erfassten Größen des vom Stromrichter aufgenommenen Stroms und der vom Stromrichter aufgenommenen Spannung mit der Soll-Ausgangsleistung des Stromrichters plausibilisiert werden.

Gemäß einer bevorzugten Weiterbildung ist vorgesehen, dass eine Drehzahl einer durch den Stromrichter betriebenen elektrischen Maschine mittels einer von der ersten Steuerelektronik unabhängigen dritten Steuerelektronik, insbesondere eines ESP-Steuergeräts, eines Getriebesteuergeräts oder eines weiteren Stromrichters, ermittelt wird.

Die ermittelte Drehzahl der elektrischen Maschine kann in vorteilhafter Weise zusätzlich zu den erfassten Größen des vom Stromrichter aufgenommenen Stroms und der vom Stromrichter aufgenommenen Spannung mit der Soll-Ausgangsleistung des Stromrichters plausibilisiert werden.

Somit kann in vorteilhafter Weise sichergestellt werden, dass der vom Stromrichter aufgenommene Strom und die vom Stromrichter aufgenommene Spannung und die Drehzahl der elektrischen Maschine mit der Soll-Ausgangsleistung des Stromrichters plausibel sind.

Gemäß einer weiteren bevorzugten Weiterbildung ist vorgesehen, dass das Ansteuern des Stromrichters das Vorgeben einer Steueranforderung an die erste Steuerelektronik umfasst. Die Steueranforderung kann beispielsweise die Vorgabe eines Drehmomentes an den Stromrichter umfassen, beispielsweise ein Drehmoment von 0. Auch kann die Steueranforderung eine Anforderung an die erste Steuerelektronik zur Überführung des Stromrichters in einen sicheren Zustand sein. Vorteilhaft wird eine Reaktionsmöglichkeit auf die Feststellung eines Fehlverhaltens des Stromrichters bereitgestellt.

Gemäß einer weiteren bevorzugten Weiterbildung ist vorgesehen, dass das Ansteuern des Stromrichters ein Abschalten des Stromrichters umfasst, falls die vorgegebene Steueranforderung fehlerhaft umgesetzt wird, wobei das Abschalten des Stromrichters innerhalb einer Fehlerreaktionszeit des Stromrichters durchgeführt wird. Somit kann der Stromrichter in vorteilhafter Weise innerhalb der Fehlerreaktionszeit in einen sicheren Zustand überführt werden.

Gemäß einer weiteren bevorzugten Weiterbildung ist vorgesehen, dass die Ist-Ausgangsleistung des Stromrichters unter Verwendung eines elektrischen Verlusts des Stromrichters, eines mechanischen Verlusts der elektrischen

Maschine, einer Toleranz der Ist-Ausgangsspannung und eines Ist-Ausgangsstroms des Stromrichters bestimmt wird. Somit fließen vorstehend genannte Parameter in die Bestimmung der Ist-Ausgangsleistung des Stromrichters ein, wodurch eine präzise Berechnung der Ist-Ausgangsleistung des Stromrichters ermöglicht wird.

Gemäß einer weiteren bevorzugten Weiterbildung ist vorgesehen, dass das Abschalten der Leistungselektronik ein Schalten einer "enable line" des Stromrichters auf "low" umfasst. Nur falls ein Pegel der "enable line" auf "high" ist, ist ein Betreiben der Endstufen des Stromrichters möglich. Der Pegel der "enable line" ist insbesondere auf "high", falls eine anliegende Spannung einen Schwellwert überschreitet. Wenn der Pegel der "enable line" auf "low" liegt, ist ein Energiefluss durch die Endstufen der Leistungselektronik nicht möglich.

Gemäß der Erfindung ist vorgesehen, dass die Strom-/Spannungs-Sensoreinrichtung in einer Traktionsbatterie eines Elektro- oder Hybridfahrzeugs integriert ist. Somit kann in vorteilhafter Weise eine bereits vorhandene Strom-/Spannungs-Sensoreinrichtung zur Bestimmung des vom Stromrichter aufgenommenen Stroms und der vom Stromrichter aufgenommenen Spannung verwendet werden.

Gemäß einer weiteren bevorzugten Weiterbildung ist vorgesehen, dass die Vorrichtung eine von der ersten Steuerelektronik unabhängige dritte Steuerelektronik umfasst, die insbesondere durch ein ESP-Steuergerät, ein Getriebesteuergerät oder einen weiteren Stromrichter ausgebildet ist, wobei die dritte Steuerelektronik dazu eingerichtet ist, eine Drehzahl einer durch den Stromrichter betriebenen elektrischen Maschine zu ermitteln. Die ermittelte Drehzahl der elektrischen Maschine trägt somit in vorteilhafter Weise dazu bei, zusätzlich zu dem vom Stromrichter aufgenommenen Strom und der vom Stromrichter aufgenommenen Spannung mit Soll-Ausgangsleistung plausibilisiert zu werden.

### Kurze Beschreibung der Zeichnungen

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung.

Andere Ausführungsformen und viele der genannten Vorteile ergeben sich im Hinblick auf die Zeichnungen. Die dargestellten Elemente der Zeichnungen sind nicht notwendigerweise maßstabsgetreu zueinander gezeigt.

Es zeigen:
- Fig. 1: ein Blockschaltbild einer Vorrichtung zur externen Überwachung eines Stromrichters gemäß einer bevorzugten Ausführungsform der Erfindung; und
- Fig. 2: ein Ablaufdiagramm eines Verfahrens zur externen Überwachung des Stromrichters gemäß der bevorzugten Ausführungsform der Erfindung.

In den Figuren der Zeichnungen bezeichnen gleiche Bezugszeichen gleiche oder funktionsgleiche Elemente, Bauteile oder Komponenten, soweit nichts Gegenteiliges angegeben ist.

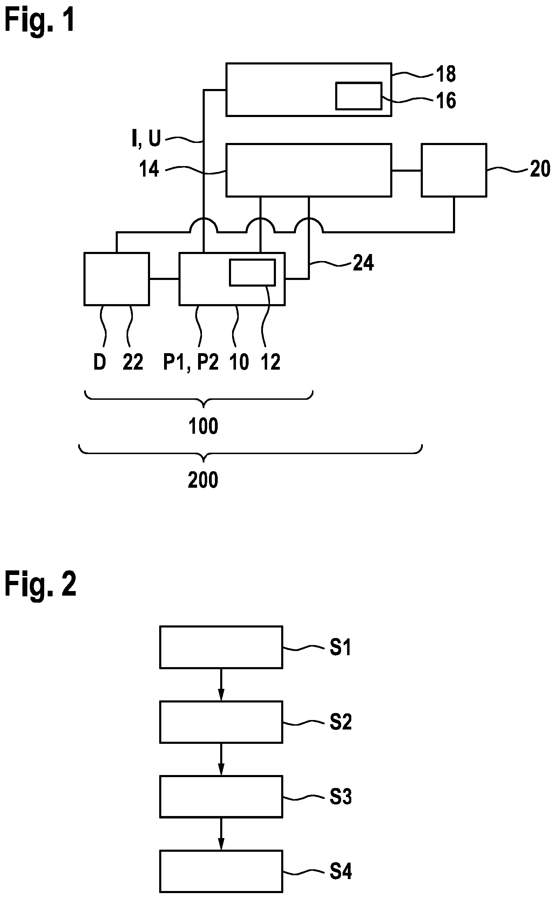

Fig. 1 zeigt ein Blockschaltbild einer Vorrichtung zur externen Überwachung eines Stromrichters gemäß einer bevorzugten Ausführungsform der Erfindung.

Die Vorrichtung zur Überwachung eines Stromrichters 10 weist zumindest eine zweite Steuerelektronik 14, eine Strom-/Spannungs-Sensoreinrichtung 16 und eine von einer ersten Steuerelektronik 12 unabhängige dritte Steuerelektronik 20 auf.

Der Stromrichter 10 wird mittels der ersten Steuerelektronik 12 angesteuert. Die Vorrichtung weist die von der ersten Steuerelektronik 12 unabhängige zweite Steuerelektronik 14 auf. Die zweite Steuerelektronik 14 ist dazu eingerichtet, durch eine von der ersten Steuerelektronik 12 unabhängige Strom-/Spannungs-Sensoreinrichtung 16, einen vom Stromrichter 10 aufgenommenen Strom I und eine vom Stromrichter aufgenommene Spannung U zu erfassen.

Ferner ist die zweite Steuerelektronik 14 dazu ausgebildet, unter Verwendung dieser Größen eine vom Stromrichter 10 bereitgestellte Ist-Ausgangsleistung P1 zu ermitteln.

Darüber hinaus ist die zweite Steuerelektronik 14 dazu ausgebildet, eine Differenz der ermittelten Ist-Ausgangsleistung P1 und einer Soll-Ausgangsleistung P2 des Stromrichters 10 zu bestimmen.

Ferner ist die zweite Steuerelektronik 14 dazu ausgebildet, den Stromrichter 10 anzusteuern, falls ein Betrag einer Differenz der Ist-Ausgangsleistung P1 und der Soll-Ausgangsleistung P2 des Stromrichters 10 einen vorbestimmten Grenzwert überschreitet.

Die Strom-/Spannungs-Sensoreinrichtung 16 ist beispielsweise in einer Traktionsbatterie 18 eines Elektro- oder Hybridfahrzeugs integriert.

Ferner ist im Rahmen der Vorrichtung die von der ersten Steuerelektronik 12 unabhängige dritte Steuerelektronik 20 vorgesehen. Die dritte Steuerelektronik 20 kann beispielsweise durch ein ESP-Steuergerät ausgebildet sein. Alternativ kann die dritte Steuerelektronik 20 beispielsweise durch ein Getriebesteuergerät oder einen weiteren Stromrichter ausgebildet sein.

Die dritte Steuerelektronik 20 ist dazu ausgebildet, die Drehzahl D einer durch den Stromrichter 10 betriebenen elektrischen Maschine 22 zu ermitteln. Ferner ist symbolisch ein Antriebsstrang 100 eines Kraftfahrzeugs 200 sowie das Kraftfahrzeug 200 dargestellt.

Fig. 2 zeigt ein Ablaufdiagramm eines Verfahrens zur externen Überwachung des Stromrichters gemäß der bevorzugten Ausführungsform der Erfindung.

Das Verfahren zur externen Überwachung des Stromrichters 10 wird derart ausgeführt, dass der Stromrichter 10 mittels einer ersten Steuerelektronik 12 angesteuert und das Verfahren mittels einer von der ersten Steuerelektronik 12 unabhängigen zweiten Steuerelektronik 14 ausgeführt wird.

Das Verfahren umfasst ein Erfassen S1 eines vom Stromrichter 10 aufgenommenen Stroms I und einer vom Stromrichter 10 aufgenommenen Spannung U durch eine von der ersten Steuerelektronik 12 unabhängige Strom-/Spannungs-Sensoreinrichtung 16.

Das Verfahren umfasst ferner ein Ermitteln S2 einer vom Stromrichter 10 bereitgestellten Ist-Ausgangsleistung P1 unter Verwendung der erfassten Größen des vom Stromrichter 10 aufgenommenen Stroms I und der vom Stromrichter 10 aufgenommenen Spannung U.

Das Verfahren umfasst ferner ein Bestimmen S3 einer Differenz der ermittelten Ist-Ausgangsleistung P1 und einer Soll-Ausgangsleistung P2 des Stromrichters 10.

Das Verfahren umfasst überdies ein Ansteuern S4 des Stromrichters 10, falls ein Betrag einer Differenz der Ist-Ausgangsleistung P1 und der Soll-Ausgangsleistung P2 des Stromrichters 10 einen vorbestimmten Grenzwert überschreitet.

Eine Drehzahl D einer durch den Stromrichter 10 betriebenen elektrischen Maschine 22 kann optional mittels einer von der ersten Steuerelektronik 12 unabhängigen dritten Steuerelektronik 20, insbesondere eines ESP Steuergeräts, eines Getriebesteuergeräts oder eines weiteren Stromrichters 10, ermittelt werden.

Eine Fahrzeugsteuereinheit (VCU) gibt der elektrischen Maschine 22 ein Soll-Drehmoment vor, wobei unter Verwendung der ermittelten Drehzahl D der elektrischen Maschine 22 hieraus eine Soll-Ausgangsleistung P2 des Stromrichters 10 berechnet wird.

Der vom Stromrichter 10 aufgenommene Strom und die vom Stromrichter 10 aufgenommene Spannung werden mit der Soll-Ausgangsleistung P2 des Stromrichters 10 durch die zweite Steuerelektronik 14 plausibilisiert. Das Ansteuern des Stromrichters 10 umfasst beispielsweise das Vorgeben einer Steueranforderung an die erste Steuerelektronik 12.

Das Ansteuern des Stromrichters 10 umfasst ein Abschalten des Stromrichters 10, falls die vorgegebene Steueranforderung fehlerhaft umgesetzt wird, wobei das Abschalten des Stromrichters 10 innerhalb einer Fehlerreaktionszeit des Stromrichters 10 durchgeführt wird.

Die Ist-Ausgangsleistung P1 des Stromrichters 10 wird beispielsweise unter Verwendung eines elektrischen Verlusts des Stromrichters 10, eines mechanischen Verlusts der elektrischen Maschine, einer Toleranz einer Ist-Ausgangsspannung und eines Ist-Ausgangsstroms des Stromrichters 10 bestimmt. Das Abschalten der Leistungselektronik umfasst optional ein Schalten einer "enable line" des Stromrichters 10 auf "low".

## Patentansprüche

1. Verfahren zur externen Überwachung eines Stromrichters (10), wobei der Stromrichter (10) mittels einer ersten Steuerelektronik (12) angesteuert und das Verfahren mittels einer von der ersten Steuerelektronik (12) unabhängigen zweiten Steuerelektronik (14) ausgeführt wird, mit den Schritten:
Erfassen (S1) eines vom Stromrichter (10) aufgenommenen Stroms (I) und einer vom Stromrichter (10) aufgenommenen Spannung (U) durch eine von der ersten Steuerelektronik (12) unabhängige Strom-/Spannungs-Sensoreinrichtung (16); Ermitteln (S2) einer vom Stromrichter (10) bereitgestellten Ist-Ausgangsleistung (P1) unter Verwendung der erfassten Größen des vom Stromrichter (10) aufgenommenen Stroms (I) und der vom Stromrichter (10) aufgenommenen Spannung (U);
Bestimmen (S3) einer Differenz der ermittelten Ist-Ausgangsleistung (P1) und einer Soll-Ausgangsleistung (P2) des Stromrichters (10); und
Ansteuern (S4) des Stromrichters (10), falls ein Betrag einer Differenz der Ist-Ausgangsleistung (P1) und der Soll-Ausgangsleistung (P2) des Stromrichters (10) einen vorbestimmten Grenzwert überschreitet
**dadurch gekennzeichnet, dass**
die Strom-/ Spannungs-Sensoreinrichtung (16) in einer Traktionsbatterie (18) eines Elektro- oder Hybridfahrzeugs integriert ist.

2. Verfahren nach Anspruch 1, **dadurch gekennzeichnet, dass** eine Drehzahl (D) einer durch den Stromrichter (10) betriebenen elektrischen Maschine (22) mittels einer von der ersten Steuerelektronik (12) unabhängigen dritten Steuerelektronik (20), insbesondere eines ESP Steuergeräts, eines Getriebesteuergeräts oder eines weiteren Stromrichters (10), ermittelt wird.

3. Verfahren nach einem der vorhergehenden Ansprüche, **dadurch gekennzeichnet, dass** das Ansteuern des Stromrichters (10) das Vorgeben einer Steueranforderung an die erste Steuerelektronik (12) umfasst.

4. Verfahren nach Anspruch 3, **dadurch gekennzeichnet, dass** das Ansteuern des Stromrichters (10) ein Abschalten des Stromrichters (10) umfasst, falls die vorgegebene Steueranforderung fehlerhaft umgesetzt wird, wobei das Abschalten des Stromrichters (10) innerhalb einer Fehlerreaktionszeit des Stromrichters (10) durchgeführt wird.

5. Verfahren nach Anspruch 4, **dadurch gekennzeichnet, dass** das Abschalten der Leistungselektronik ein Schalten einer "enable line" (24) des Stromrichters (10) auf "low" umfasst.

6. Computerprogrammprodukt, umfassend Befehle, die bewirken, dass eine Vorrichtung nach einem der Ansprüche 8 bis 9 das Verfahren nach einem der Ansprüche 1 bis 5 ausführt.

7. Maschinenlesbares Speichermedium, auf dem das Computerprogrammprodukt nach Anspruch 6 gespeichert ist.

8. Vorrichtung zur Überwachung eines Stromrichters (10), wobei der Stromrichter (10) mittels einer ersten Steuerelektronik (12) angesteuert wird, wobei die Vorrichtung eine unabhängige zweite Steuerelektronik (14) umfasst, die dazu eingerichtet ist, durch eine von der ersten Steuerelektronik (12) unabhängige Strom-/Spannungs-Sensoreinrichtung (16) einen vom Stromrichter (10) aufgenommenen Strom (I) und eine vom Stromrichter (10) aufgenommene Spannung (U) zu erfassen, daraus eine vom Stromrichter (10) bereitgestellte Ist-Ausgangsleistung (P1) zu ermitteln, eine Differenz der ermittelten Ist-Ausgangsleistung (P1) und einer Soll-Ausgangsleistung (P2) des Stromrichters (10) zu bestimmen, und den Stromrichter (10) anzusteuern, falls ein Betrag einer Differenz der Ist-Ausgangsleistung (P1) und der Soll-Ausgangsleistung (P2) des Stromrichters (10) einen vorbestimmten Grenzwert überschreitet,
**dadurch gekennzeichnet, dass**
die Strom-/ Spannungs-Sensoreinrichtung (16) in einer Traktionsbatterie (18) eines Elektro- oder Hybridfahrzeugs integriert ist.

9. Vorrichtung nach Anspruch 8, mit einer von der ersten Steuerelektronik (12) unabhängigen dritten Steuerelektronik (20), insbesondere eines ESP-Steuergeräts, eines Getriebesteuergeräts oder eines weiteren Stromrichters, welche dazu ausgebildet ist, eine Drehzahl (D) einer durch den Stromrichter (10) betriebenen elektrischen Maschine (22) zu ermitteln.

10. Antriebsstrang (100) eines Kraftfahrzeugs (200) mit einer Vorrichtung nach Anspruch 8, einem Stromrichter (10), einer ersten Steuerelektronik (12) und einer elektrischen Maschine (22) oder einer Energiequelle.

11. Kraftfahrzeug (200) mit einem Antriebsstrang (100) nach Anspruch 10.

## Claims

1. Method for externally monitoring a converter (10), wherein the converter (10) is actuated by means of first control electronics (12) and the method is carried out by means of second control electronics (14), which are independent of the first control electronics (12), having the steps of:
detecting (S1) a current (I) received by the converter (10) and a voltage (U) received by the converter (10) by means of a current/voltage sensor device (16) that is independent of the first control electronics (12);
ascertaining (S2) an actual output power (P1) provided by the converter (10), by using the captured variables of the current (I) received by the converter (10) and the voltage (U) received by the converter (10);
determining (S3) a difference between the ascertained actual output power (P1) and a setpoint output power (P2) of the converter (10); and
actuating (S4) the converter (10) if an absolute value of a difference between the actual output power (P1) and the setpoint output power (P2) of the converter (10) exceeds a predetermined limit value,
**characterized in that**
the current/voltage sensor device (16) is integrated in a traction battery (18) of an electric or hybrid vehicle.

2. Method according to Claim 1, **characterized in that** a speed (D) of an electric machine (22) operated by the converter (10) is ascertained by means of third control electronics (20), in particular of an ESP control unit, of a gearbox control unit or of a further converter (10), that are independent of the first control electronics (12) .

3. Method according to either of the preceding claims, **characterized in that** the actuating of the converter (10) comprises the specifying of a control requirement for the first control electronics (12).

4. Method according to Claim 3, **characterized in that** the actuating of the converter (10) comprises a switching-off of the converter (10) if the specified control requirement is implemented erroneously, wherein the switching-off of the converter (10) is performed within an error reaction time of the converter (10).

5. Method according to Claim 4, **characterized in that** the switching-off of the power electronics comprises a switching of an "enable line" (24) of the converter (10) to "low".

6. Computer program product, comprising commands which have the effect that an apparatus according to either of Claims 8 and 9 carries out the method according to one of Claims 1 to 5.

7. Machine-readable storage medium on which the computer program product according to Claim 6 is stored.

8. Apparatus for monitoring a converter (10), wherein the converter (10) is actuated by means of first control electronics (12), wherein the apparatus comprises independent second control electronics (14) configured to use a current/voltage sensor device (16), which is independent of the first control electronics (12), to detect a current (I) received by the converter (10) and a voltage (U) received by the converter (10), to ascertain therefrom an actual output power (P1) provided by the converter (10), to determine a difference between the ascertained actual output power (P1) and a setpoint output power (P2) of the converter (10), and to actuate the converter (10) if an absolute value of a difference between the actual output power (P1) and the setpoint output power (P2) of the converter (10) exceeds a predetermined limit value,
**characterized in that**
the current/voltage sensor device (16) is integrated in a traction battery (18) of an electric or hybrid vehicle.

9. Apparatus according to Claim 8, having third control electronics (20), in particular of an ESP control unit, of a gearbox control unit or of a further converter, that are independent of the first control electronics (12) and designed to ascertain a speed (D) of an electric machine (22) operated by the converter (10).

10. Drivetrain (100) of a motor vehicle (200) having an apparatus according to Claim 8, a converter (10), first control electronics (12) and an electric machine (22) or an energy source.

11. Motor vehicle (200) having a drivetrain (100) according to Claim 10.

## Revendications

1. Procédé de surveillance extérieure d'un convertisseur de puissance (10), le convertisseur de puissance (10) étant commandé au moyen d'un premier système de commande électronique (12) et le procédé étant mis en œuvre au moyen d'un deuxième système de commande électronique (14) indépendant du premier système de commande électronique (12), ledit procédé comprenant les étapes suivantes :
détecter (S1) un courant (I), reçu par le convertisseur de puissance (10), et une tension (U), reçue par le convertisseur de puissance (10), par le biais d'un module formant capteur de courant/tension (16) indépendant du premier système de commande (12) électronique ;
déterminer (S2) une puissance de sortie réelle (P1), fournie par le convertisseur de puissance (10), à l'aide des grandeurs détectées du courant (I), reçu par le convertisseur de puissance (10), et de la tension (U), reçue par le convertisseur de puissance (10) ; déterminer (S3) une différence entre la puissance de sortie réelle déterminée (P1) et une puissance de sortie cible (P2) du convertisseur de puissance (10) ; et
commander (S4) le convertisseur de puissance (10), si la valeur absolue de la différence entre la puissance de sortie réelle (P1) et la puissance de sortie cible (P2) du convertisseur de puissance (10) devient supérieure à une valeur limite prédéterminée,
**caractérisé en ce que**
le module formant capteur de courant/tension (16) est intégré dans une batterie de traction (18) d'un véhicule électrique ou hybride.

2. Procédé selon la revendication 1, **caractérisé en ce qu'**une vitesse de rotation (D) d'une machine électrique (22) actionnée par le convertisseur de puissance (10) est déterminée au moyen d'un troisième système de commande électronique (20) indépendant du premier système de commande électronique (12), en particulier d'une unité de commande ESP, d'une unité de commande de transmission ou d'un autre convertisseur de puissance (10).

3. Procédé selon l'une des revendications précédentes, **caractérisé en ce que** la commande du convertisseur de puissance (10) comprend la spécification d'une demande de commande au premier système de commande électronique (12).

4. Procédé selon la revendication 3, **caractérisé en ce que** la commande du convertisseur de puissance (10) comprend la désactivation du convertisseur de puissance (10) si la demande de commande spécifiée est mise en œuvre de manière erronée, la désactivation du convertisseur de puissance (10) étant effectuée pendant un temps de réaction aux erreurs du convertisseur de puissance (10).

5. Procédé selon la revendication 4, **caractérisé en ce que** la désactivation de l'électronique de puissance comprend la commutation d'une ligne de validation « enable line » (24) du convertisseur de puissance (10) sur « bas ».

6. Produit programme informatique, comprenant des instructions qui amènent un dispositif selon l'une des revendications 8 à 9 à mettre en œuvre le procédé selon l'une des revendications 1 à 5.

7. Support de stockage lisible par machine sur lequel est stocké le produit programme informatique selon la revendication 6.

8. Dispositif de surveillance d'un convertisseur de puissance (10), le convertisseur de puissance (10) étant commandé par un premier système de commande électronique (12),
le dispositif comprenant un deuxième système de commande électronique indépendant (14) qui est conçu pour détecter un courant (I), reçu par le convertisseur de puissance (10), et une tension (U), reçue par le convertisseur de puissance (10), par le biais d'un module formant capteur de courant/tension (16) indépendant du premier système de commande électronique (12) et déterminer à partir de là une puissance de sortie réelle (P1) fournie par le convertisseur de puissance (10), déterminer une différence entre la puissance de sortie réelle déterminée (P1) et une puissance de sortie cible (P2) du convertisseur de puissance (10), et commander le convertisseur de puissance (10) si la valeur absolue de la différence entre la puissance de sortie réelle (P1) et la puissance de sortie cible (P2) du convertisseur de puissance (10) devient supérieure à une valeur limite prédéterminée,
**caractérisé en ce que**
le module formant capteur de courant/tension (16) est intégré dans une batterie de traction (18) d'un véhicule électrique ou hybride.

9. Dispositif selon la revendication 8, comprenant un troisième système de commande électronique (20) indépendant du premier système de commande électronique (12), en particulier d'une unité de commande ESP, d'une unité de commande de transmission ou d'un autre convertisseur de puissance, qui est conçue pour déterminer une vitesse de rotation (D) d'une machine électrique (22) actionnée par le convertisseur de puissance (10).

10. Chaîne cinématique (100) d'un véhicule automobile (200), laquelle comprend un dispositif selon la revendication 8, un convertisseur de puissance (10), un premier système de commande électronique (12) et une machine électrique (22) ou une source d'énergie.

11. Véhicule automobile (200) comprenant une chaîne cinématique (100) selon la revendication 10.
